# EUROPEAN PATENT APPLICATION

(11) **EP 2 200 090 A1**
(43) Date of publication of application: **23.06.2010**
(21) Application number: 08830437.3
(22) Date of filing: 29.08.2008
(51) Int. Cl.: H01L 31/04

(54) **INTEGRATED TANDEM-TYPE THIN FILM SILICON SOLAR CELL MODULE AND METHOD FOR MANUFACTURING THE SAME**

(30) Priority: 10.09.2007 JP 2007233750
(71) Applicant: Murata, Masayoshi, Nagasaki 852-8027 (JP)
(72) Inventor: Murata, Masayoshi, Nagasaki 852-8027 (JP)
(74) Representative: ten Brink, Carsten
(86) International application number: PCT/JP2008/065529
(87) International publication number: WO 2009/034858

(57) **Abstract**

Provided is a tandem-type thin film silicon solar cell module having a structure wherein an intermediate layer is arranged. The module suppresses a problem of a current leak through the intermediate layer and has high light conversion efficiency by suppressing expansion of an ineffective area not contributing to power generation. A method for manufacturing such module is also provided. The module has a structure wherein a separating groove is arranged between the intermediate layer and a connecting groove, the separating groove is embedded with a crystalline silicon film, and a separating member does not exist between the separating groove and the connecting groove.

## Description

### TECHNICAL FIELD

The present invention relates to a structure of an integrated tandem-type thin film silicon solar cell module and a method for manufacturing the same. In particular, the present invention relates to an integrated tandem-type thin film silicon solar cell module having an intermediate layer and a method for manufacturing the same.

### BACKGROUND ART

The combined use of a top cell and a bottom cell having differing absorption bands in a multi-junction photoelectric conversion element that provides a photoelectric conversion function and in which a plurality of semiconductor photoelectric conversion units are stacked is known to be very effective for enhancing power generation conversion efficiency in, for example, a solar cell.
In the multi-junction photoelectric conversion element, further enhancement of power generation conversion efficiency is attempted by a transparent intermediate layer being provided with a function for performing spectral distribution of incident light energy to each connected unit, such as being provided with a function for reflecting short wavelength light and transmitting long wavelength light.

Specifically, an integrated tandem-type thin film silicon solar cell is formed by a transparent electrode, an amorphous silicon photoelectric conversion unit layer, an intermediate layer, a crystalline silicon photoelectric conversion unit layer, and a back surface electrode being sequentially stacked on a light-transmissive substrate (such as glass). The intermediate layer is provided with a function for reflecting short wavelength light and transmitting long wavelength light.
The amorphous silicon photoelectric conversion unit layer is configured by a p-type semiconductor layer, an i-type semiconductor layer, an n-type semiconductor layer, and the like. The crystalline silicon photoelectric conversion unit layer is configured by a p-type microcrystalline semiconductor, an i-type microcrystalline semiconductor layer, an n-type microcrystalline semiconductor layer, and the like.
This solar cell in which amorphous silicon and crystalline silicon are used in combination, referred to as an integrated tandem-type thin film solar cell, is expected to achieve increased photoelectric conversion efficiency of 10% to 15% on an actual production line.

A representative example of the integrated tandem-type thin film solar cell module is described, for example, in Patent Literature 3.
In Patent Literature 3, an integrated tandem-type thin film solar cell module is described in which a plurality of tandem-type thin film solar cells are arrayed and electrically interconnected in series. The tandem-type thin film solar cell is configured by a transparent electrode, a first thin film photoelectric conversion unit including an amorphous photoelectric conversion layer, an intermediate layer having conductivity, light-transmissivity, and light-reflectivity, a second thin film photoelectric conversion unit including a crystalline photoelectric conversion layer, and a back surface electrode sequentially stacked on a transparent substrate. The tandem-type thin film solar cell also includes: a first separating groove having an opening on an interface between the transparent electrode and the first thin film photoelectric conversion unit, and a bottom surface on an interface between the transparent electrode and the transparent substrate; a connecting groove having an opening on an interface between the back surface electrode and the second thin film photoelectric conversion unit, and a bottom surface on an interface between the first thin film photoelectric conversion unit and the transparent electrode, and filled with a material configuring the back surface electrode; and a second separating groove positioned away from the connecting groove, having an opening on an upper surface of the back surface electrode and a bottom surface on an interface between the first thin film photoelectric conversion unit and the transparent electrode.
However, in the representative structure described above, the intermediate layer having high conductivity and the connecting groove filled with a conductive material configuring the back surface electrode are in contact, causing a problem in which an electrical short-circuit state occurs. In other words, generated electrical current leaks from the intermediate layer to the connecting groove, causing a problem in that enhancement of photoelectric conversion efficiency becomes very difficult.

As recent attempts to solve this problem, an integrated tandem-type thin film silicon solar cell module having a new structure is proposed in, for example, Patent Literature 1 and Patent Literature 2.

In Patent Literature 1, a thin film photoelectric conversion module is described that includes a transparent substrate and a plurality of hybrid-type thin film photoelectric conversion cells arrayed on one main surface of the transparent substrate and interconnected in series. The plurality of thin film photoelectric conversion cells are configured by a transparent front surface electrode layer, a first thin film photoelectric conversion unit including an amorphous photoelectric conversion layer, an intermediate reflective layer having conductivity as well as both light-transmissivity and light-reflectivity, a second thin film photoelectric conversion unit including a crystalline photoelectric conversion layer, and a back surface electrode, sequentially stacked on the one main surface of the transparent substrate. Between each thin film photoelectric conversion cell and its adjacent thin film photoelectric conversion cell, the transparent front surface electrode layer is divided by a first separating groove. The first separating groove is filled with a material configuring the first thin film photoelectric conversion unit. A second separating groove is provided in a position away from the first separating groove. The second separating groove has an opening on an upper surface of the back surface electrode, and a bottom surface configured by an interface between the transparent front surface electrode layer and the first thin film photoelectric conversion unit. A connecting groove is provided between the first separating groove and the second separating groove. The connecting groove has an opening on an interface between the second thin film photoelectric conversion unit and the back surface electrode, and a bottom surface configured by an interface between the transparent front surface electrode layer and the first thin film photoelectric conversion unit. The connecting groove is filled with a material configuring the back surface electrode, thereby electrically connecting the back surface electrode of one of the two adjacent thin film photoelectric conversion cells and the transparent front surface electrode layer of the other. A third separating groove is provided in a position between the first separating groove and the connecting groove. Alternatively, the third separating groove is provided such that the first separating groove is positioned between the connecting groove and the third separating groove. The third separating groove has an opening on an interface between the intermediate reflective layer and the second thin film photoelectric conversion unit, and a bottom surface configured by an interface between the transparent front surface electrode layer and the first thin film photoelectric conversion unit. The third separating groove is filled with a material configuring the second thin film photoelectric conversion unit.

In addition, in Patent Literature 1, a thin film photoelectric conversion module is described that includes a transparent substrate and a plurality of hybrid-type thin film photoelectric conversion cells arrayed on one main surface of the transparent substrate and interconnected in series. The plurality of thin film photoelectric conversion cells are configured by a transparent front surface electrode layer, a first thin film photoelectric conversion unit including an amorphous photoelectric conversion unit, an intermediate reflective layer having conductivity as well asbothlight-transmissivity and light-reflectivity, a second thin film photoelectric conversion unit including a crystalline photoelectric conversion layer, and a back surface electrode, sequentially stacked on the one main surface of the transparent substrate. Between each thin film photoelectric conversion cell and its adjacent thin film photoelectric conversion cell, the transparent front surface electrode layer is divided by a first separating groove and a fourth separating groove that are spaced apart. The first separating groove and the fourth separating groove are filled with a material configuring the first thin film photoelectric conversion unit. A second separating groove is provided such that the fourth separating groove is positioned between the first separating groove and the second separating groove. The second separating groove has an opening on an upper surface of the back surface electrode, and a bottom surface configured by an interface between the transparent front surface electrode layer and the first thin film photoelectric conversion unit. A connecting groove is provided between the fourth separating groove and the second separating groove. The connecting groove has an opening on an interface between the second thin film photoelectric conversion unit and the back surface electrode, and a bottom surface configured by an interface between the transparent front surface electrode layer and the first thin film photoelectric conversion unit. The connecting groove is filled with a material configuring the back surface electrode, thereby electrically connecting the back surface electrode of one of the two adjacent thin film photoelectric conversion cells and the transparent front surface electrode layer of the other. A third separating groove is provided between the first separating groove and the fourth separating groove. The third separating groove has an opening on an interface between the intermediate reflective layer and the second thin film conversion unit, and a bottom surface configured by an interface between the transparent front surface electrode layer and the first thin film photoelectric conversion unit. The third separating groove is filled with a material configuring the second thin film photoelectric conversion unit.

In addition, in Patent Literature 1, a thin film photoelectric conversion module is described that includes a transparent substrate and a plurality of hybrid-type thin film photoelectric conversion cells arrayed on one main surface of the transparent substrate and interconnected in series. The plurality of thin film photoelectric conversion cells are configured by a transparent front surface electrode layer, a first thin film photoelectric conversion unit including an amorphous photoelectric conversion layer, an intermediate reflective layer having conductivity as well as both light-transmissivity and light-reflectivity, a second thin film photoelectric conversion unit including a crystalline photoelectric conversion layer, and a back surface electrode, sequentially stacked on the one main surface of the transparent substrate. Between each thin film photoelectric conversion cell and its adjacent thin film photoelectric conversion cell, the transparent front surface electrode layer is divided by a first separating groove. The first separating groove is filled with a material configuring the first thin film photoelectric conversion unit. A second separating groove is provided in a position away from the first separating groove. The second separating groove has an opening on an upper surface of the back surface electrode, and a bottom surface configured by an interface between the transparent front surface electrode layer and the first thin film photoelectric conversion unit. A connecting groove is provided between the first separating groove and the second separating groove. The connecting groove has an opening on an interface between the second thin film photoelectric conversion unit and the back surface electrode, and a bottom surface configured by an interface between the transparent front surface electrode layer and the first thin film photoelectric conversion unit. The connecting groove is filled with a material configuring the back surface electrode, thereby electrically connecting the back surface electrode of one of the two adjacent thin film photoelectric conversion cells and the transparent front surface electrode layer of the other. A third separating groove is provided in a position between the first separating groove and the connecting groove. Alternatively, the third separating groove is provided such that the first separating groove is positioned between the connecting groove and the third separating groove. The third separating groove has an opening on an interface between the intermediate reflective layer and the second thin film conversion unit, and a bottom surface configured by an interface between the transparent substrate and the transparent front surface electrode layer. The third separating groove is filled with a material configuring the second thin film photoelectric conversion unit.

In Patent Literature 1, residual stress (causing film peeling) and electrical short-circuit (conductivity is higher when a crystalline film is formed, compared to when an amorphous film is formed) attributed to the crystalline film formed in the separating grooves in the transparent electrode and its periphery are given as problems of conventional technology.

In Patent Literature 2, a thin film solar cell module is described that includes a light-transmissive substrate and a plurality of solar cells formed on the light-transmitting substrate and interconnected in series. Each solar cell includes: a transparent conductive film formed on the light-transmissive substrate; a first thin film photoelectric conversion unit formed on the transparent conductive film; an intermediate layer formed on the first thin film photoelectric conversion unit; a second thin film photoelectric conversion unit formed on the intermediate layer; a back surface electrode formed on the second thin film photoelectric conversion unit; a first separating groove dividing the transparent conductive film; a second separating groove having an opening on an upper portion of the back surface electrode and dividing the first thin film photoelectric conversion unit, the intermediate layer, and the second thin film photoelectric conversion unit; a connecting groove having an opening on an interface between the back surface electrode and the second thin film photoelectric conversion unit, and a bottom surface on an interface between the first thin film photoelectric conversion unit and the transparent conductive film, and filled with a material configuring the back surface electrode; and an intermediate layer separating section in which the intermediate layer is removed or has been altered and is no longer conductive.

In addition, in the Patent Literature 2, a width of the portion of the intermediate layer that has lost conductivity because of the intermediate layer separating section is three times the width of the connecting groove in a surface direction or more.
Furthermore, in Patent Literature 2, the intermediate layer separating section is a portion in which a component configuring the intermediate layer is aggregated and discontinuous.

Patent Literature 1: Japanese Patent Laid-open Publication No. 2002-261308 (Fig. 2 to Fig. 4)
Patent Literature 2: Japanese Patent Laid-open Publication No. 2006-313872 (Fig. 1 to Fig. 4, and Fig. 7 to Fig. 9)
Patent Literature 3: Japanese Patent No. 3755048 (Fig. 2)

### DISCLOSURE OF INVENTION

### PROBLEM TO BE SOLVED BY THE INVENTION

In addition to the problem regarding current leakage described in Patent Literature 1 and Patent Literature 2 above, the inventor of the present invention has discovered a structural problem in the module as a problem related to enhancement of power generation conversion efficiency in a conventional integrated tandem-type thin film silicon solar cell.
In other words, the conventional technologies described in Patent Literature 1 and Patent Literature 2 above solve the problem regarding leakage through the intermediate layer of some of the power generated in the photoelectric conversion unit layer of the integrated tandem-type thin film silicon solar cell. However, there is a problem related to power generation function, namely loss of area contributing to power generation as a solar cell module or, in other words, an increase in an ineffective area.
Therefore, when the conventional technologies are applied to a production line, the enhancement of power generation efficiency as a module remains difficult.

In the conventional technology described in Patent Literature 1, a connecting section between the first thin film photoelectric conversion unit and the second thin film photoelectric conversion unit is structured such that four grooves are aligned along the surface of the transparent substrate, the four grooves being the first separating groove, the second separating groove, the third separating groove, and the connecting groove. Therefore, when a laser etching process is performed, a total of at least 360µm is required as a distance in the width direction occupied by the first separating groove, the second separating groove, the third separating groove, and the connecting groove.
The above total distance is when the width of the first separating groove is 60µm, the width of the second separating groove is 60µm, the width of the third separating groove is 60µm, and the width of the connecting groove is 60µm. A distance between the centers of the first separating groove and the third separating groove is 100µm. A distance between the centers of the third separating groove and the connecting groove is 100µm. A distance between the centers of the connecting groove and the second separating groove is 100µm.
The above total is 3.6% when the width of a band-shaped cell configuring the solar cell module is 10mm. In other words, compared to that of a conventional amorphous silicon solar cell (processing width of about 240µm or 2.4%, when the laser etching process is performed), the ineffective area not contributing to power generation is extremely large.
When, for example, an annual production of the solar cell module is 40MW, the loss resulting from the ineffective area not contributing to power generation is enormous at 1.44MW.

In the conventional technology described in Patent Literature 2, a connecting section between the first thin film photoelectric conversion unit and the second thin film photoelectric conversion unit is structured such that four grooves are aligned along the surface of the transparent substrate, the four grooves being the first separating groove, the second separating groove, the intermediate layer separating section, and the connecting groove. Therefore, when the laser etching process is performed, a total of at least about 560µm is required as a distance in the width direction occupied by the first separating groove, the second separating groove, the intermediate layer separating section (the width of the portion in which the intermediate layer has lost conductivity is three times the width of the connecting groove in the surface direction or more=about 180µm), and the connecting groove. When laser-processing is performed in the intermediate layer separating section, the distance in the width direction occupied by the connecting groove may become greater than the above value when change in the intermediate layer material and the amorphous layer caused by heat spreads over an area wider than the width of the laser beam.
The above total distance is when the width of the first separating groove is 60µm, the width of the second separating groove is 60µm, the width of the separating groove in the intermediate layer is 180µm, and the width of the connecting groove is 60µm. A distance between the centers of the first separating groove and the separating groove in the intermediate layer is 200µm. A distance between the centers of the third separating groove and the connecting groove is 200µm. A distance between the centers of the connecting groove and the second separating groove is 100µm.
When the width of a band-shaped cell configuring the solar cell module is 10mm, the percentage of the ineffective area is 5.6% of the area of the overall module. In other words, compared to that of a conventional amorphous silicon solar cell (processing width of about 240µm when the laser etching process is performed), the ineffective area not contributing to power generation is extremely large.
When, for example, the width of the band-shaped cell configuring the solar cell module is 10mm, when an annual production of the solar cell module is 40MW, the loss resulting from the ineffective area not contributing to power generation is enormous at 2.24MW.

The present invention has been achieved in light of the above-described problems. An object of the present invention is to provide a structure of an integrated tandem-type thin film solar cell module and a method for manufacturing the same in which, in relation to an integrated tandem-type thin film solar cell module having an intermediate layer, prevention of current leakage through the intermediate layer and reduction of an area not contributing to power generation, namely an ineffective area, are effectively achieved.

### MEANS FOR SOLVING PROBLEM

To achieve the above-described object, an integrated tandem-type thin film solar cell module of the present invention is an integrated tandem-type thin film solar cell module in which a plurality of tandem-type thin film solar cells are arrayed and electrically interconnected in series. Each tandem-type thin film solar cell is configured by a transparent electrode, a first thin film photoelectric conversion unit including an amorphous photoelectric conversion layer, an intermediate layer having conductivity, light-transmissivity, and light-reflectivity, a second thin film photoelectric conversion unit having a crystalline photoelectric conversion layer, a back surface electrode, a first separating groove having an opening on an interface between the transparent electrode and the first thin film photoelectric conversion unit, and a bottom surface on an interface between the transparent electrode and a transparent substrate, a connecting groove having an opening on an interface between the back surface electrode and the second thin film photoelectric conversion unit, and a bottom surface on an interface between the first thin film photoelectric conversion unit and the transparent electrode, and filled with a material configuring the back surface electrode, and a second separating groove positioned away from the connecting groove, having an opening on an upper surface of the back surface electrode, and a bottom surface on an interface between the first thin film photoelectric conversion unit and the transparent electrode, sequentially stacked on the transparent substrate. A third separating groove having an opening on an interface between the second thin film photoelectric conversion unit and the intermediate layer, and a bottom surface on an interface between the intermediate layer and the first thin film photoelectric conversion unit is provided between a connecting groove-side end of the intermediate layer and the connecting groove. The third separating groove is filled with a material configuring the second thin film photoelectric conversion unit. A separated member of the intermediate layer is not present between the third separating groove and the connecting groove.

To similarly achieve the above-described object, in an integrated tandem-type thin film solar cell module of the present invention, electrical resistance between adjacent intermediate layers with the third separating groove therebetween is 100KΩ or more, and preferably 500KΩ or more.

To similarly achieve the above-described object, in an integrated tandem-type thin film solar cell module of the present invention, the intermediate layer includes at least one oxide selected from zinc oxide (ZnO), tin oxide (SnO2), indium tin oxide (ITO), titanium oxide (TiO2), and aluminum oxide (Al2O3).

To similarly achieve the above-described object, a method for manufacturing an integrated tandem-type thin film solar cell module of the present invention includes the steps of: forming a transparent electrode on a transparent substrate; forming a first separating groove; forming a first thin film photoelectric conversion unit on the transparent electrode and in the first separating groove; forming an intermediate layer on the first thin film photoelectric conversion unit; forming a third separating groove; forming a second thin film photoelectric conversion unit on the intermediate layer and in the third separating groove; forming a connecting groove; forming a back surface electrode on an upper portion of the second thin film photoelectric conversion unit and in the connecting groove; and forming a second separating groove. Processing is performed such that a side surface on the connecting groove side of the third separating groove and one side surface of the connecting groove share a same interface.

To similarly achieve the above-described object, a method for manufacturing an integrated tandem-type thin film solar cell module of the present invention includes the steps of: forming a transparent electrode on a transparent substrate; forming a first separating groove; forming a first thin film photoelectric conversion unit on the transparent electrode and in the first separating groove; forming an intermediate layer on the first thin film photoelectric conversion unit; forming a third separating groove; forming a second thin film photoelectric conversion unit on the intermediate layer and in the third separating groove; forming a connecting groove; forming a back surface electrode on an upper portion of the second thin film photoelectric conversion unit and in the connecting groove; and forming a second separating groove. When laser processing is performed to form the third separating groove, the laser processing is performed such that a separated member of the intermediate layer does not remain between the third separating groove and the connecting groove.

### EFFECT OF THE INVENTION

In the present invention, an integrated tandem-type thin film solar cell module and a method for manufacturing the same are provided, in which the integrated tandem-type thin film solar cell module provides a high-efficiency power generation function, in which current leakage through an intermediate layer is suppressed and increase in an ineffective area in an electrical connection section between adjacent tandem-type thin film solar cells is suppressed.

As a result of the present invention, efficiency of power generation by integrated tandem-type thin film solar cells can be further increased. Therefore, the present invention contributes greatly to enhancement of productivity and reduction of product costs in the thin film silicon solar cell industry.

### BRIEF DESCRIPTION OF DRAWINGS

Fig. 1 is a structural diagram schematically showing a cross-section of an integrated tandem-type thin film solar cell module according to a first embodiment of the present invention.
Fig. 2A is a diagram of a manufacturing process of the integrated tandem-type thin film solar cell module according to the first embodiment of the present invention, in which a first separating groove is formed.
Fig. 2B is a diagram of a manufacturing process of the integrated tandem-type thin film solar cell module according to the first embodiment of the present invention, in which a first thin film photoelectric conversion unit is formed and an intermediate layer is formed.
Fig. 2C is a diagram of a manufacturing process of the integrated tandem-type thin film solar cell module according to the first embodiment of the present invention, in which a separating groove in an intermediate layer is formed.
Fig. 2D is a diagram of a manufacturing process of the integrated tandem-type thin film solar cell module according to the first embodiment of the present invention, in which a second thin film photoelectric conversion unit is formed.
Fig. 2E is a diagram of a manufacturing process of the integrated tandem-type thin film solar cell module according to the first embodiment of the present invention, in which aconnecting groove is formed.
Fig. 2F is a diagram of a manufacturing process of the integrated tandem-type thin film solar cell module according to the first embodiment of the present invention, in which a back surface electrode is formed.
Fig. 2G is a diagram of a manufacturing process of the integrated tandem-type thin film solar cell module according to the first embodiment of the present invention, in which a second separating groove is formed.
Fig. 3 is a structural diagram schematically showing a cross-section of an integrated tandem-type thin film solar cell module according to a second embodiment of the present invention.
Fig. 4A is a diagram of a manufacturing process of the integrated tandem-type thin film solar cell module according to the second embodiment of the present invention, in which a first separating groove is formed.
Fig. 4B is a diagram of a manufacturing process of the integrated tandem-type thin film solar cell module according to the second embodiment of the present invention, in which a first thin film photoelectric conversion unit is formed and an intermediate layer is formed.
Fig. 4C is a diagram of a manufacturing process of the integrated tandem-type thin film solar cell module according to the second embodiment of the present invention, in which a separating groove in an intermediate layer is formed.
Fig. 4D is a diagram of a manufacturing process of the integrated tandem-type thin film solar cell module according to the second embodiment of the present invention, in which a second thin film photoelectric conversion unit is formed.
Fig. 4E is a diagram of a manufacturing process of the integrated tandem-type thin film solar cell module according to the second embodiment of the present invention, in which a connecting groove is formed.
Fig. 4F is a diagram of a manufacturing process of the integrated tandem-type thin film solar cell module according to the second embodiment of the present invention, in which a back surface electrode is formed.
Fig. 4G is a diagram of a manufacturing process of the integrated tandem-type thin film solar cell module according to the second embodiment of the present invention, in which a second separating groove is formed.
Fig. 5 is a structural diagram schematically showing a cross-section of an integrated tandem-type thin film solar cell module according to a third embodiment of the present invention.

### REFERENCE SIGNS LIST

- 1: an integrated tandem-type thin film solar cell module
- 2: a transparent substrate
- 3: a transparent electrode
- 4: a first thin film photoelectric conversion unit including an amorphous photoelectric conversion layer
- 5: an intermediate layer
- 6: a second thin film photoelectric conversion unit including a crystalline photoelectric conversion layer
- 7: a back surface electrode
- 8: a first separating groove
- 9: a second separating groove
- 10: a first intermediate layer separating groove
- 11: a connecting groove
- 12: a tandem-type thin film solar cell
- 13: a second intermediate layer separating groove
- 14: a third intermediate layer separating groove

### BEST MODE(S) FOR CARRYING OUT THE INVENTION

The best modes for carrying out the present invention will be described with reference to the drawings. In each drawing, similar components are given the same reference number. Repetitive explanations are omitted.

### First Embodiment

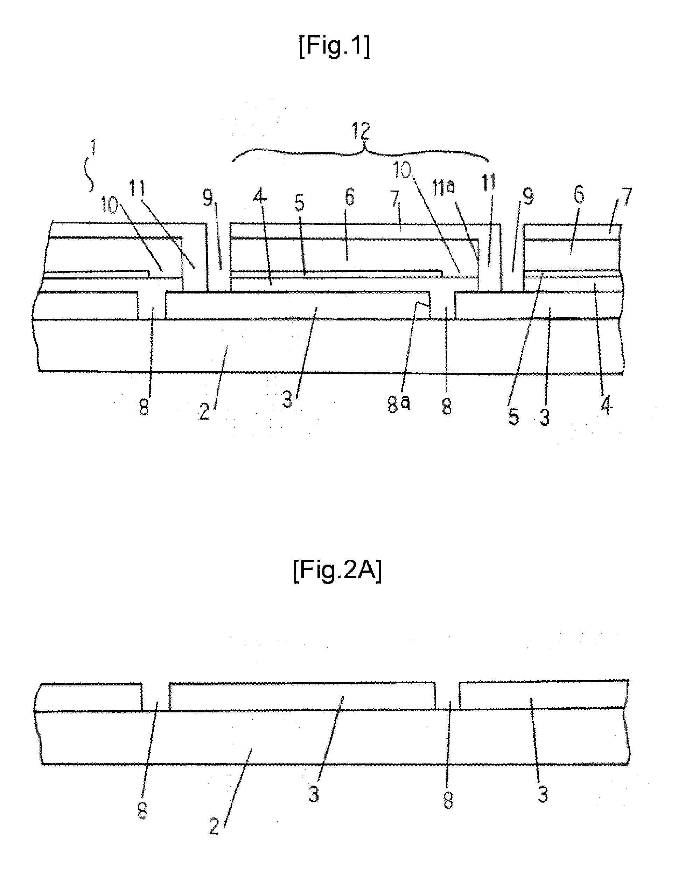

First, an integrated tandem-type thin film solar cell module according to a first embodiment of the present invention will be described with reference to Fig. 1 and Fig. 2A to Fig. 2G.
Fig. 1 is a structural diagram schematically showing a cross-section of the integrated tandem-type thin film solar cell module according to the first embodiment of the present invention. Fig. 2A to Fig. 2G are diagrams of manufacturing processes of the integrated tandem-type thin film solar cell module according to the first embodiment of the present invention.
In Fig. 1 and Fig. 2A to Fig. 2G, reference number 1 indicates the integrated tandem-type thin film solar cell module.
Reference number 12 indicates a tandem-type thin film solar cell. The tandem-type thin film solar cell 12 has a structure in which a transparent electrode 3 described hereafter, a first thin film photoelectric conversion unit 4 including an amorphous photoelectric conversion layer described hereafter, an intermediate layer 5 described hereafter, a second thin film photoelectric conversion unit 6 including a crystalline photoelectric conversion layer described hereafter, and a back surface electrode 7 described hereafter are sequentially stacked on a transparent substrate 2 described hereafter.
The tandem-type thin film solar cell 12 is divided in a direction perpendicular to a paper surface by a second separating groove 9, described hereafter. A plurality of tandem-type thin film solar cells 12 are in an array.
Reference number 2 indicates a transparent substrate, such as a glass substrate.
Reference number 3 indicates a transparent electrode that is made using a transparent and conductive material. An oxide, such as a SnO2 film, a ZnO film, or an indium tin oxide (ITO) film, is used in the transparent electrode 3. The transparent electrode 3 can be formed by, for example, a thermal chemical vapor deposition (CVD) technique, a sputtering method, or a physical vapor deposition (PVD) technique. Here, an aluminum-doped ZnO film is formed using the sputtering technique. The surface of the transparent electrode 3 is preferably formed having a textured structure including fine recesses and projections. The uneven structure of the transparent electrode 3 achieves an effect of trapping solar light incident on the first thin film photoelectric conversion unit including an amorphous photoelectric conversion layer and the second thin film photoelectric conversion unit including a crystalline photoelectric conversion layer, described hereafter. The uneven structure is known to contribute to enhancement of photoelectric conversion efficiency. The thickness of the transparent electrode 3 is generally 0.2µm to 1.0µm and is preferably, for example, 0.5µm.
Reference number 4 indicates the first thin film photoelectric conversion unit including an amorphous photoelectric conversion layer. The first thin filmphotoelectric conversion unit 4 includes an amorphous photoelectric conversion layer and has a structure in which, for example, a p-type silicon semiconductor layer, an amorphous silicon photoelectric conversion layer, and an n-type silicon semiconductor layer are sequentially stacked. The p-type silicon semiconductor layer, the amorphous silicon photoelectric conversion layer, and the n-type silicon semiconductor layer can all be formed by a plasma CVD technique. The thickness of the first thin film photoelectric conversion unit 4 is generally 0.1µm to 0.6µm and is preferably, for example, 0.3µm.

Reference number 5 indicates an intermediate layer in which a material having conductivity, light-transmissivity, and light-reflectivity is used. An oxide, such as a Sn02 film, a ZnO film, or an indium tin oxide (ITO) film, is used in the intermediate layer 5. The intermediate layer 5 can be formed by, for example, a thermal chemical vapor deposition (CVD) technique, a sputtering method, or a physical vapor deposition (PVD) technique. Here, an aluminum-doped ZnO film is formed using the sputtering technique. The surface of the intermediate layer 5 is preferably formed having a textured structure including fine recesses and projections. The uneven structure of the intermediate layer 5 achieves an effect of trapping solar light incident on the first thin film photoelectric conversion unit 4 including an amorphous photoelectric conversion layer and the second thin film photoelectric conversion unit including a crystalline photoelectric conversion layer, described hereafter. The uneven structure is known to contribute to enhancement of photoelectric conversion efficiency. The thickness of the intermediate layer 5 is generally 20nm to 90nm and is preferably, for example, 40nm to 60nm.
Reference number 6 indicates the second thin film photoelectric conversion unit including a crystalline photoelectric conversion layer. The second thin film photoelectric conversion unit 6 includes a crystalline photoelectric conversion layer and has a structure in which, for example, a p-type silicon semiconductor layer, a crystalline silicon photoelectric conversion layer, and an n-type silicon semiconductor layer are sequentially stacked. The p-type silicon semiconductor layer, the crystalline silicon photoelectric conversion layer, and the n-type silicon semiconductor layer can all be formed by a plasma CVD technique. The thickness of the second thin film photoelectric conversion unit 6 is generally 1.5µm to 6µm and is preferably, for example, 2µm.
Reference number 7 indicates a back surface electrode that is a thin film made of a metal, such as silver and aluminum. The back surface electrode 7 functions as a light-reflective layer, in addition to functioning as an electrode. The back surface electrode 7 can be formed by a physical vapor deposition technique or a sputtering technique. The thickness of the back surface electrode 7 is 100nm to 400nm and is preferably, for example, 300nm.
Reference number 8 is a first separating groove that extends in a direction perpendicular to the paper surface. The first separating groove 8 divides the transparent electrode 3 in correspondence with the tandem-type thin film solar cells 12. The first separating groove 8 has an opening on an interface between the transparent electrode 3 and the first thin film photoelectric conversion unit 4, and a bottom surface on the surface of the transparent substrate 2. The first separating groove 8 is filled with an amorphous silicon film that configures the first thin film photoelectric conversion unit 4. Because the amorphous silicon film is highly electrically insulative, an area between the transparent electrodes 3 configuring adjacent tandem-type thin film solar cells 12 is electrically insulated by the first separating groove 8. Reference number 8a indicates one side surface configuring the first separating groove 8. The side surface 8a extends in the direction perpendicular to the paper surface.
Reference number 9 indicates a second separating groove provided in a position away from the first separating groove 8. The second separating groove 9 has an opening on the upper surface of the back surface electrode 7, and a bottom surface on an interface between the transparent electrode 3 and the first thin film photoelectric conversion unit 4. The second separating groove 9 divides the first thin film photoelectric conversion unit 4, the second thin film photoelectric conversion unit 6, the intermediate layer 5, and the back surface electrode 7, in correspondence with the tandem-type thin film solar cells 12, in the direction perpendicular to the paper surface.

Reference number 10 indicates a first intermediate layer separating groove. The first intermediate layer separating groove 10 has a spatial structure having an opening on an interface between the intermediate layer 5 and the second thin film photoelectric conversion unit 6, and a bottom surface on an interface between the intermediate layer 5 and the first thin film photoelectric conversion unit 4, in an area between a side surface 11a of a connecting groove 11, described hereafter, and a surface that is an extension of the side surface 8a of the first separating groove 8 in a normal direction of the upper surface of the transparent substrate. The one side surface 11a of the connecting groove 11 and one end surface of the first intermediate layer separating groove 10 share the same interface.
The separating groove 10 is provided in a direction perpendicular to the paper surface, between the intermediate layer 5 and the connecting groove 11, described hereafter.
The first intermediate layer separating groove 10 is filled with a crystalline silicon film that configures the second thin film photoelectric conversion unit 6. Because the crystalline silicon film is highly electrically insulative, an area between the intermediate layer 5 and the connecting groove 11 is electrically insulated.
When the intermediate layer separating groove 10 is formed, as described hereafter, a laser etching process is performed such that a separated portion of the intermediate layer 5 does not remain between the intermediate layer 5 and the connecting groove 11. Therefore, electrical insulation between the intermediate layer 5 and the connecting groove 11 can be maintained with certainty.
The above-described matter means the following: the separated portion of the intermediate layer 5 remains in the conventional technology, making electrical insulation between the intermediate layer 5 and the connecting groove 11 difficult to maintain with certainty; however, the separated portion of the intermediate layer 5 does not remain in the present invention and, therefore has no effect.
Reference number 11 is a connecting groove having an opening on an interface between the second thin film photoelectric conversion unit 6 and the back surface electrode 7, and a bottom surface on an interface between the transparent electrode 3 and the first thin film photoelectric conversion unit 4. As a result of the connecting groove 11 being filled with a material that configures the back surface electrode 7, the back surface electrode 7 of one of two adjacent tandem-type thin film solar cells 12 and the transparent electrode 3 of the other are electrically connected.
Reference number 11a indicates one side surface configuring the connecting groove 11. The one side surface 11a of the connecting groove 11 extends in the direction perpendicular to the paper surface.

According to the first embodiment of the present invention, the integrated tandem-type thin film solar cell module 1, described above, can be manufactured by a method described below. First, for example, a piece of glass that is 110cm×140cm in size and 0.5cm thick is prepared as the transparent substrate 2. A SnO2 film or a ZnO film, such as an Al-doped ZnO film, is formed on the transparent substrate 2 as the transparent electrode 3 using a thermal CVD device or a sputtering device. For example, a sputtering device (not shown) is used.
Next, the first separating groove 8 shown in Fig. 2A is formed on the transparent electrode 3. In Fig. 2A, areas indicated by the reference number 8 are formed by laser etching using a pulsed YAG laser (not shown) in parallel with the 110cm edge of the transparent substrate 2, such that the distance between centers is, for example, 10mm, and the groove width is, for example, 40µm.
For example, 1.06µm is selected as the wavelength of the laser. Regarding the output of the laser, a processing test is performed in advance. Conditions selected based on data from the processing test are used, such as a pulse width of 35ns, a repeated oscillation frequency of 25KHz, and an average output of 10W.

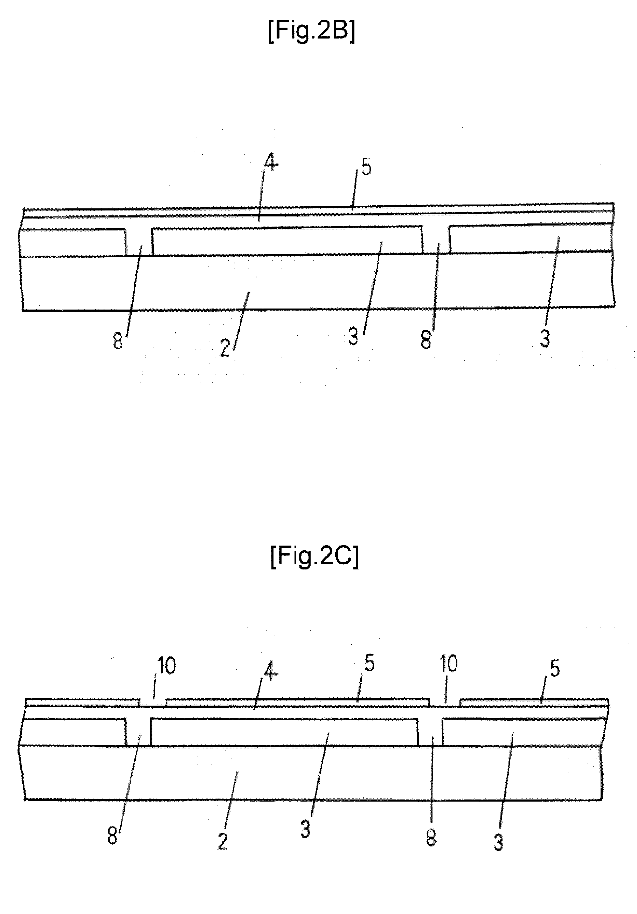

Next, as shown in Fig. 2B, the first thin film photoelectric conversion unit 4 is formed on the transparent electrode 3 using a plasma CVD device (not shown).
As a result of the first thin film photoelectric conversion unit 4 being formed, the first separating groove 8 formed in the transparent electrode 3 is filled with the amorphous silicon film configuring the first thin film photoelectric conversion unit 4. The amorphous silicon film is highly electrically insulative. Therefore, electrical resistance between adjacent transparent electrodes 3 divided by the first separating groove 8 is very high.
Next, as shown in Fig. 2B, for example, an Al-doped ZnO film is formed on the first thin film photoelectric conversion unit 4 as the intermediate layer 5 using a sputtering device (not shown). The thickness of the intermediate layer 5 is within a range from 20nm to 90nm and is, for example, 50nm.

Next, as shown in Fig. 2C, the first intermediate layer 5 separating groove 10 is formed using a laser etching device that uses a pulsed YAG laser (not shown).
For example, 0.532µm is selected as the wavelength of the laser. Regarding the output of the laser, a processing test is performed in advance. Conditions selected based on data from the processing test are used, such as a pulse width of 35ns, a repeated oscillation frequency of 10KHz, and an average output of 15W.
Here, as laser processing conditions for the intermediate layer 5, conditions are selected such that residual portions of the intermediate layer 5 from laser processing do not remain. In addition, a tester (not shown) is used to measure electrical resistance between adjacent intermediate layers 5 with the separating groove 10 therebetween to check that the measured value is 100KΩ or more, and preferably 500 KΩ or more. The measured value is closely related to shunt resistance, which is an important parameter of power generation performance of the integrated tandem-type thin film solar cell module 1 being manufactured. The measured value is very significant in terms of preventing leakage of the generated electrical current. When a residual portion from laser processing that remains when laser processing is performed is not removed, maintaining the measured value at 100KΩ or more becomes difficult.
In Fig. 2C, the laser beam from the laser etching device (not shown) is applied from the film surface side of the intermediate layer 5 in a direction along the groove of the first separating groove 8, with the center position of the laser beam at, for example, 40µm from the center point of the first separating groove 8 and a laser beam width of 80µm. As a result, as shown in Fig. 2C, a band-shaped intermediate layer 5 separating groove 10 having a width of 80µm is obtained with a distance between the center positions of the first separating groove 8 and the intermediate layer 5 separating groove 10 at 40µm.
When processing the width of 80µm in the intermediate layer 5 in a single laser etching process is difficult, processing can be easily performed by, for example, performing laser etching twice at a width of 40µm. The distance between the centers of the first separating groove 8 and the first intermediate layer 5 separating groove 10 can be set arbitrarily. The width of the first intermediate layer 5 separating groove 10 can also be set arbitrarily.
Rather than from the film surface side of the intermediate layer 5, processing can also be performed with the laser beam being irradiated from the opposite direction.

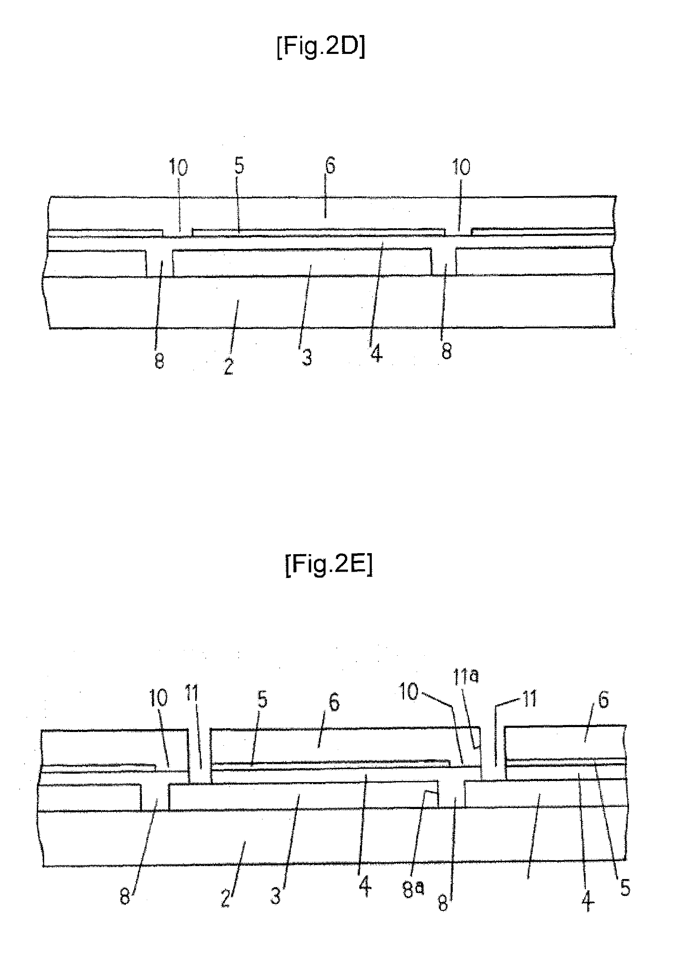

Next, as shown in Fig. 2D, the second thin film photoelectric conversion unit 6 is formed on the intermediate layer 5 and in the first intermediate layer 5 separating groove 10.
As a result of the second thin film photoelectric conversion unit 6 being formed, the first intermediate layer 5 separating groove 10 is filled with a material (a crystalline silicon film that is much more electrically insulative than the material of the intermediate layer) configuring the second thin film photoelectric conversion unit 6.
Here, the crystalline silicon film formed on the intermediate layer 5 is formed such that a film having a higher crystallinity is formed, even at an early film stage of deposition. However, the first intermediate layer 5 separating groove 10 tends to be filled with a crystalline silicon film at an early stage of deposition, namely an amorphous film.

Next, as shown in Fig. 2E, the connecting groove 11 is formed by a laser etching device using a pulsed YAG laser (not shown).
For example, 0.532µm is selected as the wavelength of the laser. Regarding the output of the laser, a processing test is performed in advance. Conditions selected based on data from the processing test are used, such as a pulse width of 35ns, a repeated oscillation frequency of 10KHz, and an average output of 15W.
The connecting groove 11 has an opening on the upper surface of the second thin film photoelectric conversion unit 6, and a bottom surface on an interface between the transparent electrode 3 and the first thin film photoelectric conversion unit 4. The groove width is 40µm to 80µm and is, for example, 60µm.
The distance between the center of the first separating groove 8 and the center of the connecting groove 11 is, for example, 110µm.
Here, regarding processing conditions for the connecting groove 11, confirmation is made that laser processing is performed under processing conditions in which a separated member and residue of the intermediate layer 5 that are formed during the laser processing do not remain between the intermediate layer 5 and the side surface 11a of the connecting groove 11. The side surface 11a of the connecting groove 11 is observed under an optical microscope to confirm that the separated member and residue of the intermediate layer 5 do not remain.

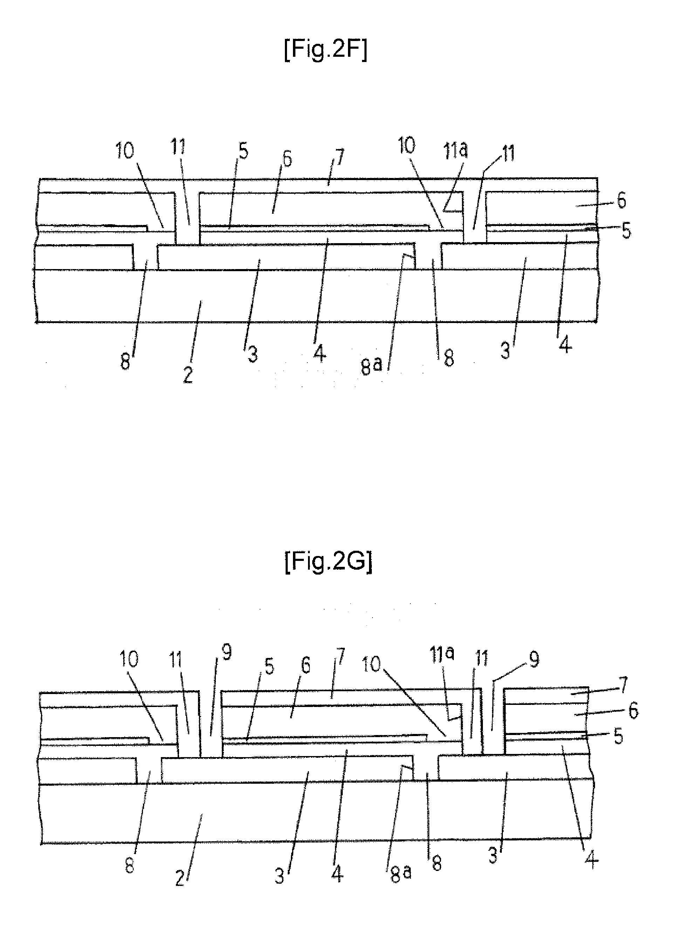

Next, as shown in Fig. 2F, Ag is formed as the back surface electrode 7 on the second thin film photoelectric conversion unit 6 and in the connecting groove 11, for example, with a thickness of 300nm using a sputtering device (not shown).
As a result of the back surface electrode 7 being formed, the connecting groove 11 is filled with the material configuring the back surface electrode 7. As a result, the back surface electrode 7 of one of two adjacent tandem-type thin film solar cells 12 and the transparent electrode 3 of the other are electrically connected.

Next, as shown in Fig. 2G, the second separating groove 9 is formed using a laser etching device that uses a pulsed YAG laser (not shown).
For example, 0.532µm is selected as the wavelength of the laser. Regarding the output of the laser, a processing test is performed in advance. Conditions selected based on data from the processing test are used, such as a pulse width of 35ns, a repeated oscillation frequency of 10KHz, and an average output of 20W.
As shown in Fig. 2G, the second separating groove 9 is provided in a position away from the first separating groove 8. The second separating groove 9 has an opening on the upper surface of the back surface electrode 7, and a bottom surface on an interface between the transparent electrode 3 and the first thin film photoelectric conversion unit 4. The second separating groove 9 divides the first thin film photoelectric conversion unit 4, the second thin film photoelectric conversion unit 6, the intermediate layer 5, and the back surface electrode 7 in correspondence with the tandem-type thin film solar cells 12, in the direction perpendicular to the paper surface.
The groove width is 40µm to 80µm and is, for example, 60µm. The distance between the center of the connecting groove 11 and the center of the second separating groove 9 is, for example, 70µm.
In Fig. 2G, processing-residue portions of the first thin film photoelectric conversion unit 4, the second thin film photoelectric conversion unit 6, the intermediate layer 5, and the back surface electrode 7 are not shown in the boundary areas between the connecting groove 11 and the second separating groove 9. Whether a processing-residue portion remains depends on the processing precision of the laser etching device. However, even should a processing-residue portion remain, the processing-residue portion does not affect the power generation performance of the integrated multi-junction thin film silicon solar cell module 1.

Next, a peripheral groove (not shown) is formed in the periphery of the transparent substrate 2 using the laser etching device that uses a pulsed YAG laser (not shown), and a power generation area is defined.
In this instance, for example, 0.532µm is selected as the wavelength of the laser. Regarding the output of the laser, a processing test is performed in advance. Conditions selected based on data from the processing test are used, such as a pulse width of 35ns, a repeated oscillation frequency of 10KHz, and an average output of 15W.

Here, the percentage of the ineffective area is as follows. In other words, the width of the band-shaped tandem-type thin film silicon solar cell configuring the module is, for example, 10mm. The width of the first separating groove 8 is 40µm. The width of the second separating groove 9 is 60µm. The distance between the center of the first separating groove 8 and the center of the connecting groove 11 is 110µm. The distance between the center of the connecting groove 11 and the center of the second separating groove 9 is 70µm. Therefore, the total ineffective width is 20µm+110µm+70µm+30µm=230µm.
Therefore, the ineffective area is 2.3% of the area of the band-shaped cell having the width of 10mm. In other words, compared to the ineffective area being 3.6% in the technology described in Patent Literature 1 and the ineffective area being 5.6% in the technology described in Patent Literature 2, a significantly smaller value can be achieved.

In the integrated tandem-type thin film solar cell module 1 according to the first embodiment, described above, portions of the first separating groove 8 and the first intermediate layer 5 separating groove 10 dividing the transparent electrode 3 overlap when viewed in the width direction of the first separating groove 8. In other words, the first separating groove 8 and the first intermediate layer 5 separating groove 10 are disposed having a positional relationship in which a portion or the entirety of the projections of the first separating groove 8 and the first intermediate layer 5 separating groove 10 overlap, when viewed from a normal direction of the surface of the transparent substrate. Therefore, the area not contributing to power generation can be minimized.
The intermediate layer 5 is separated from the connecting groove 11 by the first intermediate layer 5 separating groove 10. In addition, the first intermediate layer 5 separating groove 10 is filled with crystalline silicon configuring the second thin film photoelectric conversion unit 6. Therefore, current leakage can be prevented.
In other words, according to the first embodiment, an integrated tandem-type thin film solar cell module and a method for manufacturing the same can be provided in which the integrated tandem-type thin film solar cell module provides a high-efficiency power generation function, in which current leakage through an intermediate layer is suppressed and increase in an ineffective area in an electrical connection section between adjacent tandem-type thin film solar cells is suppressed.
Moreover, efficiency of power generation by the integrated tandem-type thin film solar cell module can be further increased. Therefore, the contribution to enhancement of productivity and reduction of product costs in the thin film silicon solar cell industry is very significant.

### Second Embodiment

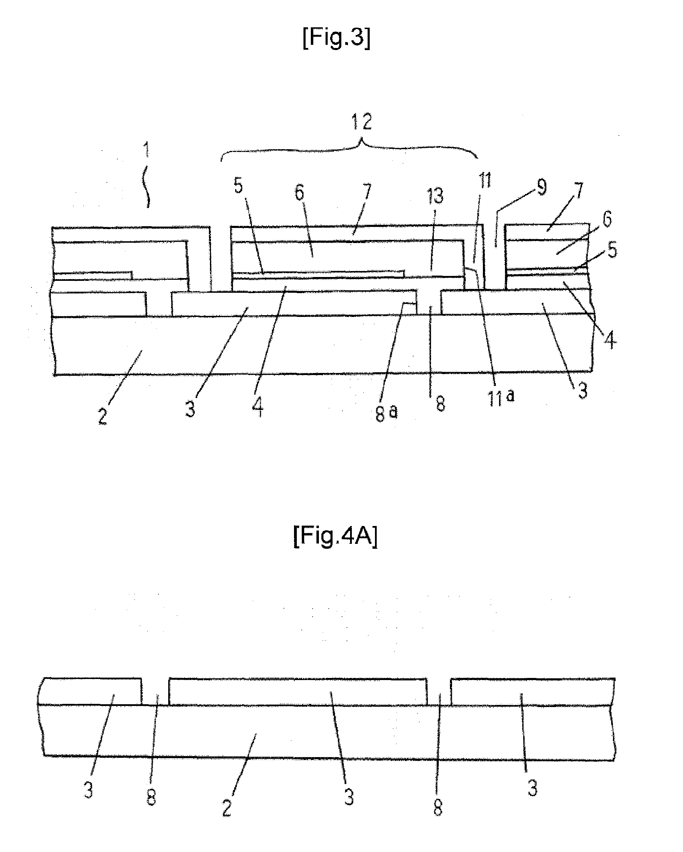

Next, an integrated tandem-type thin film solar cell module according to a second embodiment of the present invention will be described with reference to Fig. 3 and Fig. 4A to Fig. 4G.
Fig. 3 is a structural diagram schematically showing a cross-section of the integrated tandem-type thin film solar cell module according to the second embodiment of the present invention. Fig. 4A to Fig. 4G are diagrams of manufacturing processes of the integrated tandem-type thin film solar cell module according to the second embodiment of the present invention.

In Fig. 3 and Fig. 4A to Fig. 4G, reference number 13 indicates a second intermediate layer separating groove. The second intermediate layer separating groove 13 has a spatial structure having an opening on an interface between the intermediate layer 5 and the second thin film photoelectric conversion unit 6, and a bottom surface on an interface between the intermediate layer 5 and the first thin film photoelectric conversion unit 4, in an area between the side surface 11a of the connecting groove 11 and the outer side (direction moving away from the side surface 11a of the connecting groove 11) of a surface that is an extension of the side surface 8a of the first separating groove 8 in a normal direction of the upper surface of the transparent substrate 2. The one side surface 11a of the connecting groove 11 and one end surface of the second intermediate layer separating groove 13 share the same interface.
The second intermediate layer separating groove 13 is provided in a direction perpendicular to the paper surface, between the intermediate layer 5 and the connecting groove 11.
The second intermediate layer separating groove 13 is filled with the crystalline silicon film that configures the second thin film photoelectric conversion unit 6. Because the crystalline silicon film is highly electrically insulative, the area between the intermediate layer 5 and the connecting groove 11 is electrically insulated.
When the second intermediate layer separating groove 13 is formed, as describedhereafter, a laser etchingprocess is performed such that a separated portion of the intermediate layer 5 does not remain between the intermediate layer 5 and the connecting groove 11. Therefore, electrical insulation between the intermediate layer 5 and the connecting groove 11 can be maintained with certainty.
The above-described matter means the following: the separated portion of the intermediate layer 5 remains in the conventional technology, making electrical insulation between the intermediate layer 5 and the connecting groove 11 difficult to maintain with certainty; however, the separated portion of the intermediate layer 5 does not remain in the present invention and, therefore has no effect.
Reference numbers 2 to 12 are the same as those described with reference to the diagram schematically showing the cross-section of the integrated multi-junction thin film silicon solar cell module according to the first embodiment of the present invention shown in Fig. 1 and Fig. 2A to Fig. 2G. Explanations thereof are omitted.

According to the second embodiment of the present invention, the integrated tandem-type thin film solar cell module 1 can be manufactured by a method described below.
First, for example, a piece of glass that is 110cm×140cm in size and 0.5cm thick is prepared as the transparent substrate 2. A SnO2 film or a ZnO film, such as an Al-doped ZnO film, is formed on the transparent substrate 2 as the transparent electrode 3 using a thermal CVD device or a sputtering device. For example, a sputtering device (not shown) is used.
Next, the first separating groove 8 shown in Fig. 4A is formed on the transparent electrode 3. In Fig. 4A, areas indicated by the reference number 8 are formed by laser etching using a pulsed YAG laser (not shown) in parallel with the 110cm edge of the transparent substrate 2, such that the distance between centers is, for example, 10mm, and the groove width is, for example, 40µm.
For example, 1.06µm is selected as the wavelength of the laser. Regarding the output of the laser, a processing test is performed in advance. Conditions selected based on data from the processing test are used, such as a pulse width of 35ns, a repeated oscillation frequency of 25KHz, and an average output of 10W.

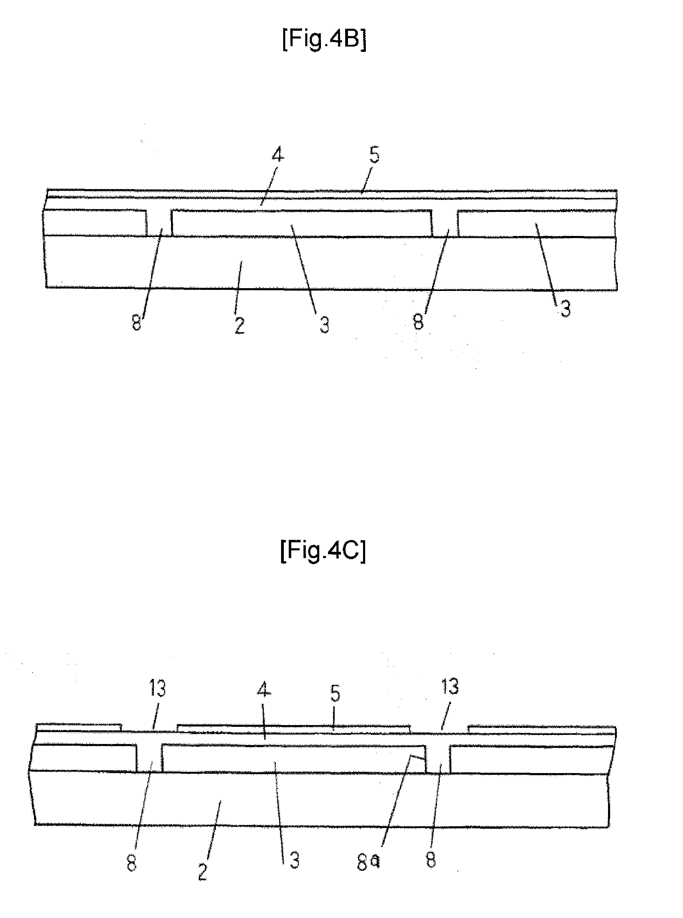

Next, as shown in Fig. 4B, the first thin film photoelectric conversion unit 4 is formed on the transparent electrode 3 using a plasma CVD device (not shown).
As a result of the first thin film photoelectric conversion unit 4 being formed, the first separating groove 8 formed in the transparent electrode 3 is filled with the amorphous silicon film configuring the first thin film photoelectric conversion unit 4. The amorphous silicon film is highly electrically insulative. Therefore, electrical resistance between adjacent transparent electrodes 3 divided by the first separating groove 8 is very high.
Next, as shown in Fig. 4B, for example, an Al-doped ZnO film is formed on the first thin film photoelectric conversion unit 4 as the intermediate layer 5 using a sputtering device (not shown). The thickness of the intermediate layer 5 is within a range from 20nm to 90nm and is, for example, 50nm.

Next, as shown in Fig. 4C, the second intermediate layer 5 separating groove 13 is formed using a laser etching device that uses a pulsed YAG laser (not shown).
For example, 0.532µm is selected as the wavelength of the laser. Regarding the output of the laser, a processing test is performed in advance. Conditions selected based on data from the processing test are used, such as a pulse width of 35ns, a repeated oscillation frequency of 10KHz, and an average output of 15W.
Here, as laser processing conditions for the intermediate layer 5, conditions are selected such that residual portions of the intermediate layer 5 from laser processing do not remain. In addition, a tester (not shown) is used to measure electrical resistance between adjacent intermediate layers 5 with the separating groove 13 therebetween to check that the measured value is 100KΩ or more, and preferably 500 KΩ or more. The measured value is closely related to shunt resistance, which is an important parameter of power generation performance of the integrated tandem-type thin film solar cell module 1 being manufactured. The measured value is very significant in terms of preventing leakage of the generated electrical current. When a residual portion from laser processing that remains when laser processing is performed is not removed, maintaining the measured value at 100KΩ or more becomes difficult.
In Fig. 4C, the laser beam from the laser etching device (not shown) is applied from the film surface side of the intermediate layer 5 in a direction along the groove of the first separating groove 8, with the center position of the laser beam at a same position as, for example, the center point of the first separating groove 8 and a laser beam width of 80µm. As a result, as shown in Fig. 4C, a band-shaped second intermediate layer separating groove 13 having a width of 80µm and a center position that is the same as that of the first separating groove 8 is obtained.
When processing the width of 80µm in the intermediate layer 5 in a single laser etching process is difficult, processing can be easily performed by, for example, performing laser etching twice at a width of 40µm. The distance between the centers of the first separating groove 8 and the second intermediate layer 5 separating groove 13 can be set arbitrarily. The width of the second intermediate layer separating groove 13 can also be set arbitrarily.
Rather than from the film surface side of the intermediate layer 5, processing can also be performed with the laser beam being irradiated from the opposite direction.

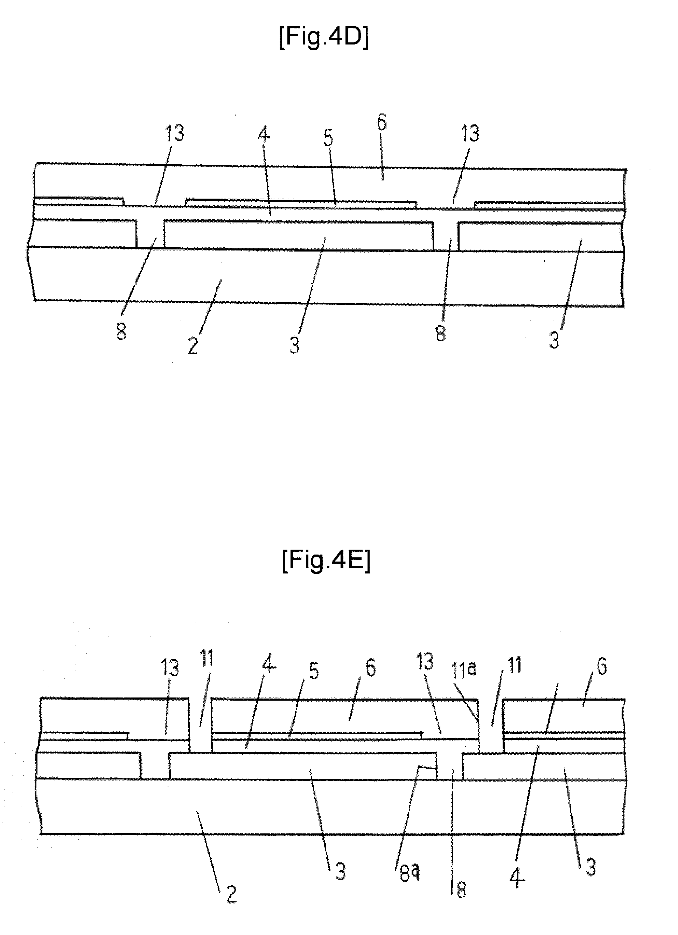

Next, as shown in Fig. 4D, the second thin film photoelectric conversion unit 6 is formed on the intermediate layer 5 and in the second intermediate layer separating groove 13.
As a result of the second thin film photoelectric conversion unit 6 being formed, the second intermediate layer 5 separating groove 13 is filled with a material (a crystalline silicon film that is much more electrically insulative than the material of the intermediate layer) configuring the second thin film photoelectric conversion unit 6.

Next, as shown in Fig. 4E, the connecting groove 11 is formed by a laser etching device using a pulsed YAG laser (not shown).
For example, 0.532µm is selected as the wavelength of the laser. Regarding the output of the laser, a processing test is performed in advance. Conditions selected based on data from the processing test are used, such as a pulse width of 35ns, a repeated oscillation frequency of 10KHz, and an average output of 15W.
The connecting groove 11 has an opening on the upper surface of the second thin film photoelectric conversion unit 6, and a bottom surface on an interface between the transparent electrode 3 and the first thin film photoelectric conversion unit 4. The groove width is 40µm to 80µm and is, for example, 60µm.
The distance between the center of the first separating groove 8 and the connecting groove 11 is, for example, 70µm.
Here, regarding processing conditions for the connecting groove 11, confirmation is made that laser processing is performed under processing conditions in which a separated member and residue of the intermediate layer 5 that are formed during the laser processing do not remain between the intermediate layer 5 and the side surface 11a of the connecting groove 11. The side surface 11a of the connecting groove 11 is observed under an optical microscope to confirm that the separated member and residue of the intermediate layer 5 do not remain.

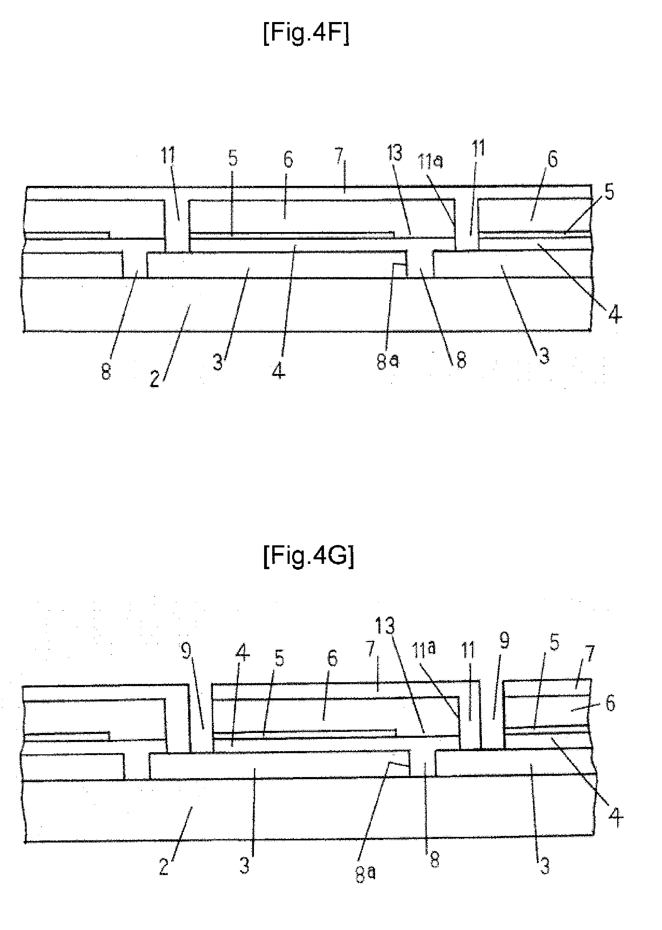

Next, as shown in Fig. 4F, Ag is formed as the back surface electrode 7 on the second thin film photoelectric conversion unit 6 and in the connecting groove 11, for example, with a thickness of 300nm using a sputtering device (not shown).
As a result of the back surface electrode 7 being formed, the connecting groove 11 is filled with the material configuring the back surface electrode 7. As a result, the back surface electrode 7 of one of two adjacent tandem-type thin film solar cells 12 and the transparent electrode 3 of the other are electrically connected.

Next, as shown in Fig. 4G, the second separating groove 9 is formed using a laser etching device that uses a pulsed YAG laser (not shown).
For example, 0.532µm is selected as the wavelength of the laser. Regarding the output of the laser, a processing test is performed in advance. Conditions selected based on data from the processing test are used, such as a pulse width of 35ns, a repeated oscillation frequency of 10KHz, and an average output of 20W.
As shown in Fig. 4G, the second separating groove 9 is provided in a position away from the first separating groove 8. The second separating groove 9 has an opening on the upper surface of the back surface electrode 7, and a bottom surface on an interface between the transparent electrode 3 and the first thin film photoelectric conversion unit 4. The second separating groove 9 divides the first thin film photoelectric conversion unit 4, the second thin film photoelectric conversion unit 6, the intermediate layer 5, and the back surface electrode 7 in correspondence with the tandem-type thin film solar cells 12, in the direction perpendicular to the paper surface.
The groove width is 40µm to 80µm and is, for example, 60µm. The distance between the center of the connecting groove 11 and the center of the second separating groove 9 is, for example, 70µm.
In Fig. 4G, processing-residue portions of the first thin film photoelectric conversion unit 4, the second thin film photoelectric conversion unit 6, the intermediate layer 5, and the back surface electrode 7 are not shown in the boundary areas between the connecting groove 11 and the second separating groove 9. Whether a processing-residue portion remains depends on the processing precision of the laser etching device. However, even should a processing-residue portion remain, the processing-residue portion does not affect the power generation performance of the integrated tandem-type thin film silicon solar cell module 1.

Next, a peripheral groove (not shown) is formed in the periphery of the transparent substrate 2 using the laser etching device that uses a pulsed YAG laser (not shown), and a power generation area is defined.
In this instance, for example, 0.532µm is selected as the wavelength of the laser. Regarding the output of the laser, a processing test is performed in advance. Conditions selected based on data from the processing test are used, such as a pulse width of 35ns, a repeated oscillation frequency of 10KHz, and an average output of 15W.

Here, the percentage of the ineffective area is as follows. In other words, the width of the band-shaped tandem-type thin film silicon solar cell configuring the module is, for example, 10mm. The width of the first separating groove 8 is 40µm. The width of the second intermediate layer separating groove 13 is 80µm. The width of the second separating groove 9 is 60µm. The distance between the center of the first separating groove 8 and the center of the connecting groove 11 is 70µm. The distance between the center of the connecting groove 11 and the center of the second separating groove 9 is 70µm. Therefore, the total ineffective width is 40µm+70µm+70µm+30µm=210µm.
Therefore, the ineffective area is 2.1% of the area of the band-shaped cell having the width of 10mm. In other words, compared to the ineffective area being 3.6% in the technology described in Patent Literature 1 and the ineffective area being 5.6% in the technology described in Patent Literature 2, a significantly smaller value can be achieved.

In the integrated tandem-type thin film solar cell module 1 according to the second embodiment, described above, the first separating groove 8 dividing the transparent electrode 3 and the second intermediate layer separating groove 13 overlap when viewed in the width direction of the first separating groove 8. In other words, the first separating groove 8 and the second intermediate layer separating groove 13 are disposed having a positional relationship in which a portion or the entirety of the projections of the first separating groove 8 and the second intermediate layer separating groove 13 overlap, when viewed from a normal direction of the surface of the transparent substrate. Therefore, the area not contributing to power generation can be minimized.
The intermediate layer 5 is separated from the connecting groove 11 by the second intermediate layer separating groove 13. In addition, the second intermediate layer separating groove 13 is filled with crystalline silicon configuring the second thin film photoelectric conversion unit 6. Therefore, current leakage can be prevented.
In other words, according to the second embodiment, an integrated tandem-type thin film solar cell module and a method for manufacturing the same can be provided in which the integrated tandem-type thin film solar cell module provides a high-efficiency power generation function, in which current leakage through an intermediate layer is suppressed and increase in an ineffective area in an electrical connection section between adjacent tandem-type thin film solar cells is suppressed.
Moreover, efficiency of power generation by the integrated tandem-type thin film solar cell module can be further increased. Therefore, the contribution to enhancement of productivity and reduction of product costs in the thin film silicon solar cell industry is very significant.

### Third Embodiment

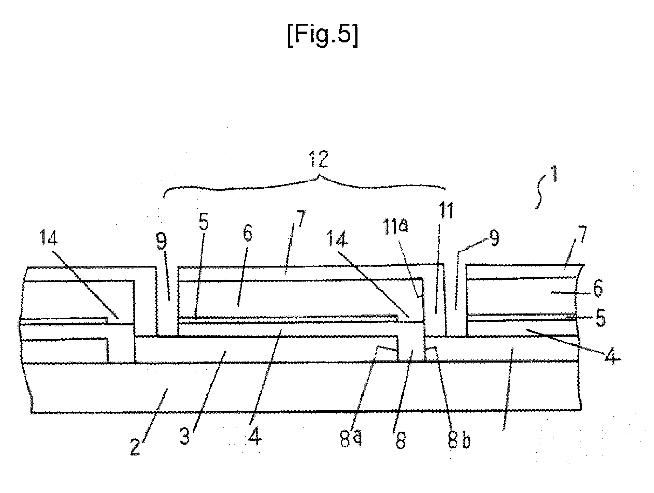

Next, an integrated tandem-type thin film solar cell module according to a third embodiment of the present invention will be described with reference to Fig. 5.
Fig. 5 is a structural diagram schematically showing a cross-section of the integrated tandem-type thin film solar cell module according to the third embodiment of the present invention.

In Fig. 5, reference number 14 indicates a third intermediate layer separating groove. The third intermediate layer separating groove 14 has a spatial structure having an opening on an interface between the intermediate layer 5 and the second thin film photoelectric conversion unit 6,and a bottom surface on an interface between the intermediate layer 5 and the first thin film photoelectric conversion unit 4. In addition, the third intermediate layer separating groove 14 is surrounded by surfaces that are two side surfaces 8a and 8b of the first separating groove 8 extended in the normal direction of the upper surface of the transparent substrate 2. The side surface 11a of the connecting groove 11 and one end surface of the third intermediate layer separating groove 14 share the same interface.
The third intermediate layer separating groove 14 is provided in a direction perpendicular to the paper surface, between the intermediate layer 5 and the connecting groove 11.
The third intermediate layer separating groove 14 is filled with the crystalline silicon film that configures the second thin film photoelectric conversion unit 6. Because the crystalline silicon film is highly electrically insulative, the area between the intermediate layer 5 and the connecting groove 11 is electrically insulated.
When the third intermediate layer separating groove 14 is formed, as described hereafter, a laser etching process is performed such that a separated portion of the intermediate layer 5 does not remain between the intermediate layer 5 and the connecting groove 11. Therefore, electrical insulation between the intermediate layer 5 and the connecting groove 11 can be maintained with certainty.
The above-described matter means the following: the separated portion of the intermediate layer 5 remains in the conventional technology, making electrical insulation between the intermediate layer 5 and the connecting groove 11 difficult to maintain with certainty; however, the separated portion of the intermediate layer 5 does not remain in the present invention and, therefore has no effect.
As described hereafter, the distance between one end surface of the third intermediate layer separating groove 14 and one end surface of the second separating groove 9 can be set such that, for example, the width of the first separating groove 8 is 40µm, the width of the connecting groove 11 is 60µm, and the width of the second separating groove 9 is 60µm. Therefore, the width of the ineffective area can be 40µm+60µm+60µm=140µm, which is shorter than those of the integrated tandem-type thin film silicon solar cell modules according to the first and second embodiments of the present invention, described above.
Reference numbers 2 to 12 are the same as those described with reference to the diagram schematically showing the cross-section of the integrated tandem-type thin film solar cell module according to the first embodiment of the present invention shown in Fig. 1 and Fig. 2A to Fig. 2G. Explanations thereof are omitted.

According to the third embodiment of the present invention, the integrated tandem-type thin film solar cell module 1 can be manufactured by a method described below. First, for example, a piece of glass that is 110cm×140cm in size and 0.5cm thick is prepared as the transparent substrate 2. A SnO2 film or a ZnO film, such as an Al-doped ZnO film, is formed on the transparent substrate 2 as the transparent electrode 3 using a thermal CVD device or a sputtering device. For example, a sputtering device (not shown) is used.
Next, the first separating groove 8 shown in Fig. 5 is formed on the transparent electrode 3. In Fig. 5, areas indicated by the reference number 8 are formed by laser etching using a pulsed YAG laser (not shown) in parallel with the 110cm edge of the transparent substrate 2, such that the distance between centers is, for example, 10mm, and the groove width is, for example, 40µm.
For example, 1.06µm is selected as the wavelength of the laser. Regarding the output of the laser, a processing test is performed in advance. Conditions selected based on data from the processing test are used, such as a pulse width of 35ns, a repeated oscillation frequency of 25KHz, and an average output of 10W.

Next, the first thin film photoelectric conversion unit 4 shown in Fig. 5 is formed on the transparent electrode 3 using a plasma CVD device (not shown).
As a result of the first thin film photoelectric conversion unit 4 being formed, the first separating groove 8 formed in the transparent electrode 3 is filled with the amorphous silicon film configuring the first thin film photoelectric conversion unit 4. The amorphous silicon film is highly electrically insulative. Therefore, electrical resistance between adjacent transparent electrodes 3 divided by the first separating groove 8 is very high.
Next, for example, an Al-doped ZnO film is formed on the first thin film photoelectric conversion unit 4 as the intermediate layer 5 shown in Fig. 5, using a sputtering device (not shown). The thickness of the intermediate layer 5 is within a range from 20nm to 90nm and is, for example, 50nm.

Next, the third intermediate layer separating groove 14 shown in Fig. 5 is formed using a laser etching device that uses a pulsed YAG laser (not shown).
For example, 0.532µm is selected as the wavelength of the laser. Regarding the output of the laser, a processing test is performed in advance. Conditions selected based on data from the processing test are used, such as a pulse width of 35ns, a repeated oscillation frequency of 10KHz, and an average output of 15W.
In Fig. 5, the laser beam from the laser etching device (not shown) is applied from the film surface side of the intermediate layer 5 in a direction along the groove of the first separating groove 8, with the center position of the laser beam at a same position as, for example, the center point of the first separating groove 8. The laser beam width is the same as that for the first separating groove 8, and is 40µm herein. As a result, as shown in Fig. 5, a band-shaped third intermediate layer separating groove 14 having a width of 40µm and a center position that is the same as that of the first separating groove 8 is obtained.
Rather than from the film surface side of the intermediate layer 5, processing can also be performed with the laser beam being irradiated from the opposite direction.

Next, the second thin film photoelectric conversion unit 6 is formed on the intermediate layer 5 and in the third intermediate layer separating groove 14 shown in Fig. 5.
As a result of the second thin film photoelectric conversion unit 6 being formed, the third intermediate layer 5 separating groove 14 is filled with a material (a crystalline silicon film that is much more electrically insulative than the material of the intermediate layer) configuring the second thin film photoelectric conversion unit 6.

Next, the connecting groove 11 shown in Fig. 5 is formed by a laser etching device using a pulsed YAG laser (not shown).
For example, 0.532µm is selected as the wavelength of the laser. Regarding the output of the laser, a processing test is performed in advance. Conditions selected based on data from the processing test are used, such as a pulse width of 35ns, a repeated oscillation frequency of 10KHz, and an average output of 15W.
The connecting groove 11 has an opening on the upper surface of the second thin film photoelectric conversion unit 6, and a bottom surface on an interface between the transparent electrode 3 and the first thin film photoelectric conversion unit 4.
The groove width is 40µm to 80µm, and is, for example, 60µm.
The distance between the center of the first separating groove 8 and the connecting groove 11 is, for example, 50µm such that a space is not formed between one end surface of the third intermediate layer separating groove 14 and one end surface 11a of the connecting groove 11.

Next, Ag is formed as the back surface electrode 7 shown in Fig. 5, on the second thin film photoelectric conversion unit 6 and in the connecting groove 11, for example, with a thickness of 300nm using a sputtering device (not shown).
As a result of the back surface electrode 7 being formed, the connecting groove 11 is filled with the material configuring the back surface electrode 7. As a result, the back surface electrode 7 of one of two adjacent tandem-type thin film solar cells 12 and the transparent electrode 3 of the other are electrically connected.

Next, the second separating groove 9 shown in Fig. 5 is formed using a laser etching device that uses a pulsed YAG laser (not shown).
For example, 0.532µm is selected as the wavelength of the laser. Regarding the output of the laser, a processing test is performed in advance. Conditions selected based on data from the processing test are used, such as a pulse width of 35ns, a repeated oscillation frequency of 10KHz, and an average output of 20W.
As shown in Fig. 5, the second separating groove 9 is provided in a position away from the first separating groove 8. The second separating groove 9 has an opening on the upper surface of the back surface electrode 7, and a bottom surface on an interface between the transparent electrode 3 and the first thin film photoelectric conversion unit 4. The second separating groove 9 divides the first thin film photoelectric conversion unit 4, the second thin film photoelectric conversion unit 6, the intermediate layer 5, and the back surface electrode 7 in correspondence with the tandem-type thin film solar cells 12, in the direction perpendicular to the paper surface.
The groove width is 40µm to 80µm and is for example, 60µm. The distance between the center of the connecting groove 11 and the center of the second separating groove 9 is, for example, 70µm.
In Fig. 5, processing-residue portions of the first thin film photoelectric conversion unit 4, the second thin film photoelectric conversion unit 6, the intermediate layer 5, and the back surface electrode 7 are not shown in the boundary areas between the connecting groove 11 and the second separating groove 9. Whether a processing-residue portion remains depends on the processing precision of the laser etching device. However, even should a processing-residue portion remain, the processing-residue portion does not affect the power generation performance of the integrated tandem-type thin film silicon solar cell module 1.

Next, a peripheral groove (not shown) is formed in the periphery of the transparent substrate 2 using the laser etching device that uses a pulsed YAG laser (not shown), and a power generation area is defined.
In this instance, for example, 0.532µm is selected as the wavelength of the laser. Regarding the output of the laser, a processing test is performed in advance. Conditions selected based on data from the processing test are used, such as a pulse width of 35ns, a repeated oscillation frequency of 10KHz, and an average output of 15W.

Here, the percentage of the ineffective area is as follows. In other words, the width of the band-shaped multi-junction thin film silicon solar cell configuring the module is, for example, 10mm. The width of the first separating groove 8 is 40µm. The width of the second separating groove 9 is 60µm. The distance between the center of the first separating groove 8 and the center of the connecting groove 11 is 50µm. The distance between the center of the connecting groove 11 and the center of the second separating groove 9 is 70µm. Therefore, the total ineffective width is 20µm+50µm+70µm+30µm=170µm.
Therefore, the ineffective area is 1.7% of the area of the band-shaped cell having the width of 10mm. In other words, compared to the ineffective area being 3.6% in the technology described in Patent Literature 1 and the ineffective area being 5. 6% in the technology described in Patent Literature 2, a significantly smaller value can be achieved.

In the integrated tandem-type thin film solar cell module 1 according to the third embodiment, described above, the first separating groove 8 dividing the transparent electrode 3 and the third intermediate layer separating groove 14 overlap when viewed in the width direction of the first separating groove 8. In other words, the first separating groove 8 and the third intermediate layer 5 separating groove 14 are disposed having a positional relationship in which a portion or the entirety of the projections of the first separating groove 8 and the third intermediate layer separating groove 14 overlap, when viewed from a normal direction of the surface of the transparent substrate. Therefore, the area not contributing to power generation can be minimized.
The intermediate layer 5 is separated from the connecting groove 11 by the third intermediate layer separating groove 14. In addition, the space is filled with crystalline silicon configuring the second thin film photoelectric conversion unit 6. Therefore, current leakage can be prevented.
In other words, according to the third embodiment, an integrated tandem-type thin film solar cell module and a method for manufacturing the same can be provided in which the integrated tandem-type thin film solar cell module provides a high-efficiency power generation function, in which current leakage through an intermediate layer is suppressed and increase in an ineffective area in an electrical connection section between adjacent tandem-type thin film solar cells is suppressed.
Moreover, efficiency of power generation by the integrated tandem-type thin film solar cell module can be further increased. Therefore, the contribution to enhancement of productivity and reduction of product costs in the thin film silicon solar cell industry is very significant.

According to the first, second, and third embodiments of the present invention described above, the integrated tandem-type thin film solar cell module of the present invention has a structure in which the intermediate layer separating groove is provided between the intermediate layer and the connecting groove configuring the integrated tandem-type thin film solar cell module. The intermediate layer separating groove and the separating groove provided in the transparent electrode are respectively disposed in positions establishing a relationship in which the intermediate layer separating groove and the separating groove provided in the transparent electrode overlap in the normal direction of the transparent electrode surface. In addition, the separating groove of the transparent electrode is filled with an amorphous silicon film, and the intermediate layer separating groove is filled with a crystalline silicon film at an early stage of deposition.
As a result, an integrated tandem-type thin film solar cell module and a method for manufacturing the same can be provided in which the integrated tandem-type thin film solar cell module provides a high-efficiency power generation function, in which current leakage through an intermediate layer is suppressed and increase in an ineffective area in an electrical connection section between adjacent tandem-type thin film solar cells is suppressed.

## Claims

1. An integrated tandem-type thin film solar cell module in which a plurality of tandem-type thin film solar cells are arrayed and electrically interconnected in series, each tandem-type thin film solar cell configured by a transparent electrode, a first thin film photoelectric conversion unit including an amorphous photoelectric conversion layer, an intermediate layer having conductivity, light-transmissivity, and light-reflectivity, a second thin film photoelectric conversion unit having a crystalline photoelectric conversion layer, a back surface electrode, a first separating groove having an opening on an interface between the transparent electrode and the first thin film photoelectric conversion unit, and a bottom surface on an interface between the transparent electrode and a transparent substrate, a connecting groove having an opening on an interface between the back surface electrode and the second thin film photoelectric conversion unit, and a bottom surface on an interface between the first thin film photoelectric conversion unit and the transparent electrode, and filled with a material configuring the back surface electrode, and a second separating groove positioned away from the connecting groove, having an opening on an upper surface of the back surface electrode, and a bottom surface on an interface between the first thin film photoelectric conversion unit and the transparent electrode, sequentially stacked on the transparent substrate, wherein:
a third separating groove having an opening on an interface between the second thin film photoelectric conversion unit and the intermediate layer, and a bottom surface on an interface between the intermediate layer and the first thin film photoelectric conversion unit is provided between a connecting groove-side end of the intermediate layer and the connecting groove,
the third separating groove is filled with a material configuring the second thin film photoelectric conversion unit, and
a separated member of the intermediate layer is not present between the third separating groove and the connecting groove.

2. The integrated tandem-type thin film solar cell module according to claim 1, wherein electrical resistance between adjacent intermediate layers with the third separating groove therebetween is 100KΩ or more, and preferably 500KΩ or more.

3. The integrated tandem-type thin film solar cell module according to claim 1 or 2, wherein the intermediate layer includes at least one oxide selected from zinc oxide (ZnO), tin oxide (SnO2), indium tin oxide (ITO), titanium oxide (TiO2), and aluminum oxide (Al2O3).

4. A method for manufacturing an integrated tandem-type thin film solar cell module, comprising the steps of:
forming a transparent electrode on a transparent substrate;
forming a first separating groove;
forming a first thin film photoelectric conversion unit on the transparent electrode and in the first separating groove;
forming an intermediate layer on the first thin film photoelectric conversion unit;
forming a third separating groove;
forming a second thin film photoelectric conversion unit on the intermediate layer and in the third separating groove;
forming a connecting groove;
forming a back surface electrode on an upper portion of the second thin film photoelectric conversion unit and in the connecting groove; and
forming a second separating groove, wherein
processing is performed such that a side surface on the connecting groove side of the third separating groove and one side surface of the connecting groove share a same interface.

5. A method for manufacturing an integrated tandem-type thin film solar cell module, comprising the steps of:
forming a transparent electrode on a transparent substrate;
forming a first separating groove
forming a first thin film photoelectric conversion unit on the transparent electrode and in the first separating groove;
forming an intermediate layer on the first thin film photoelectric conversion unit;
forming a third separating groove;
forming a second thin film photoelectric conversion unit on the intermediate layer and in the third separating groove;
forming a connecting groove;
forming a back surface electrode on an upper portion of the second thin film photoelectric conversion unit and in the connecting groove; and
forming a second separating groove, wherein
when laser processing is performed to form the third separating groove, the laser processing is performed such that a separated member of the intermediate layer does not remain between the third separating groove and the connecting groove.
